# EUROPÄISCHE PATENTSCHRIFT

(11) **EP 0 501 261 B1**
(45) Veröffentlichungstag und Bekanntmachung des Hinweises auf die Patenterteilung: **19.06.1996**
(21) Anmeldenummer: 92102554.0
(22) Anmeldetag: 15.02.1992
(51) Int. Cl.: H01L 29/10, H01L 29/735

(54) **Lateraler Bipolartransistor**
Lateral bipolar transistor
Transistor bipolaire latéral

(30) Priorität: 28.02.1991 DE 4106263; 12.11.1991 DE 4137101
(43) Veröffentlichungstag der Anmeldung: 02.09.1992
(73) Patentinhaber: Daimler-Benz Aktiengesellschaft, D-70546 Stuttgart (DE)
(72) Erfinder: Silber, Dieter, Prof. Dr., W-6053 Obertshausen 2 (DE); Bodensohn, Alexander, Dipl.-Ing., W-6452 Hainburg (DE); Korec, Jacek, Dr.-Ing., W-6082 Mörfelden-Walldorf (DE)
(74) Vertreter: Vogl, Leo, Dipl.-Ing.

(56) Entgegenhaltungen:
- EP-A- 0 281 235
- IEEE TRANSACTIONS ON ELECTRON DEVICES. Bd. 36, Nr. 9-I, September 1989, NEW YORK US Seiten 1703 - 1710; D.D.TANG ET AL.: 'The design and electrical characteristics of high-performance single-poly ion-implanted bipolar transistors'
- IEEE INTERNATIONAL SOLID STATE CIRCUITS CONFERENCE. Bd. 24, Februar 1981, NEW YORK US Seiten 216 - 217; T.SAKAI ET AL.: 'A 3ns 1Kb RAM using super self-
- aligned process technology'
- JAPANESE JOURNAL OF APPLIED PHYSICS, SUPPLEMENTS. Bd. 19-1, 1980, TOKYO JA Seiten 181 - 185; H.SAKURAI ET AL.: 'A new transistor structure for high speed bipolar LSI'
- PHILIPS JOURNAL OF RESEARCH. Bd. 35, Nr. 1, 1980, EINDHOVEN NL Seiten 1 - 13; J.A.APPELS ET AL.: 'Thin layer high-voltage devices (resurf devices)'

## Beschreibung

Die Erfindung betrifft ein laterales Halbleiterbauelement aus einem Halbleiterkörper mit einer n⁻-leitenden Driftschicht auf einem Substrat, einer in die Driftschicht eingelassenen n⁺-leitenden Kollektorzone, einer sich unterhalb der Oberfläche des Halbleiterkörpers mit Abstand von der n⁺-leitenden Kollektorzone lateral erstreckenden, p-leitenden Basiszone, einer in die p-leitende Basiszone eingelassenen n⁺-leitenden Emitterzone und mit jeweils einen Kontakt an der Basis-, Emitter- und Kollektorzone.

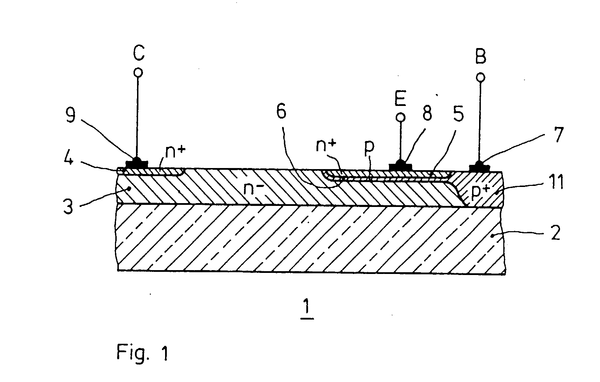

Ein derartiges laterales Halbleiterbauelement ist aus "Philips Journal of Research", Band 35, 1980, Seiten 1 bis 13 bekannt. Dieses bekannte Halbleiterbauelement ist in Fig. 1 dargestellt und wird im speziellen Beschreibungsteil noch näher erläutert.

Das bekannte laterale Halbleiterbauelement weist die bekannten Transistoreigenschaften auf, wobei die Ausgangskennlinie oberhalb der Betriebsspannung eine geringe positive Steigung aufweist, d. h. der Kollektorstrom steigt mit zunehmender Kollektorspannung in diesem Bereich der Kennlinie geringfügig an. Laterale Halbleiterbauelemente der genannten Art werden insbesondere als steuerbare Stromquellen für Spannungen oberhalb 100 V eingesetzt. Da, wie bereits erwähnt, der Kollektorstrom oberhalb der Knickspannung nicht konstant ist, entsprechen die bekannten Stromquellen nicht den an sie gestellten technischen Anforderungen.

Ein weiterer Nachteil ist auch darin zu sehen, dass die Stromquellen wie ein üblicher Transistor mit äusseren Spannungen versorgt werden müssen, d. h. für das Ein- und Ausschalten der Stromquelle sind Spannungs- oder Stromquellen zwischen den Basis- und Emitteranschlüssen erforderlich.

Der Erfindung liegt die Aufgabe zugrunde, das eingangs definierte laterale Halbleiterbauelement derart weiterzubilden, dass die Emitter- und Basisanschlüsse eine von der Kollektorspannung weitgehend unabhängige Konstantspannungsquelle bilden, die durch einen parallel geschalteten Widerstand in eine Stromquelle umgewandelt werden kann.

Diese Aufgabe wird gemäss der Erfindung dadurch gelöst, dass die Basiszone eine schwach dotierte p⁻⁻-leitende Teilzone und eine stark dotierte p⁺-leitende, mit dem Basiskontakt versehene Teilzone aufweist, dass die schwach dotierte Teilzone der Basiszone zumindest teilweise an die n⁺-leitende Emitterzone angrenzt, und dass die p⁻⁻-leitende Teilzone so schwach dotiert und/oder von der Emitterzone zur Driftzone hin ein so stark abnehmendes Dotierungsprofil aufweist, dass bei einer vorbestimmten Kollektorspannung sich die Raumladungszone des zwischen der n⁻-leitenden Driftzone und der p⁻⁻-leitenden Basiszone gebildete pn-Übergang in der p⁻⁻-leitenden Teilzone bis zur n⁺-leitenden Emitterzone erstreckt, so daß die Emitterzone mit der Driftschicht über die Raumladungszone in Verbindung steht, und daß das Substrat p-leitend ist oder eine isolierende Schicht aufweist. Dadurch baut sich eine Potentialdifferenz zwischen den Emitter- und Basisanschlüssen auf.

Da bei diesem Halbleiterbauelement oberhalb einer vorbestimmten Kollektorspannung ein weiterer Spannungsanstieg durch den Raumladungsbereich in der lateral erstreckenden p⁻⁻-leitenden Teilzone und der Driftschicht aufgefangen wird, ist die Emitter-Basis-Spannung bei geeigneter Dimensionierung praktisch unabhängig von Kollektorspannungen, die grösser als die vorbestimmte Spannung sind. Damit ist eine Konstantstromquelle mit hervorragenden Eigenschaften verfügbar. Zur Umwandlung dieser Konstantstromquelle in eine Stromquelle genügt es, wie im einzelnen noch beschrieben wird, einen regelbaren Widerstand zwischen den Basis- und den Emitteranschlüssen zu schalten. Im Gegensatz zu den bekannten lateralen Transistoren, bei denen die Stromverstärkung von der Temperatur abhängig ist, wird bei dem Halbleiterbauelement gemäss der Erfindung eine von der Temperatur praktisch unabhängige Stromquelle realisiert.

Weiterbildungen sind den Unteransprüchen zu entnehmen.

Das Wesen der Erfindung soll anhand einiger in den Zeichnungen dargestellter Ausführungsbeispiele näher erläutert werden.

Es zeigen
- Fig. 1: ein bekanntes laterales Halbleiterbauelement mit einer Transistorstruktur;
- Fig. 2: ein laterales Halbleiterbauelement gemäss der Erfindung;
- Fig. 3: ein weiteres Ausführungsbeispiel gemäss der Erfindung;
- Fig. 4: ein abgewandeltes Ausführungsbeispiel des Halbleiterbauelements gemäss Fig. 3;
- Fig. 5: ein laterales Halbleiterbauelement gemäss Fig. 4, mit einer Feldplatte zur Abschirmung der schwach dotierten Teilzone der Basiszone;
- Fig. 6: eine typische Ausgangskennlinie des Halbleiterbauelements gemäss der Erfindung: Emitter-Basis als Funktion der Kollektor-Basis-Spannung;
- Fig. 7: eine schematische Darstellung des Halbleiterbauelements gemäss der Erfindung zur Erläuterung seiner Wirkungsweise.

Bei dem in Fig. 1 dargestellten bekannten lateralen Halbleiterbauelement besteht der Halbleiterkörper 1 aus einem p-leitenden Substrat 2, auf dem sich eine n⁻-leitende Schicht 3 befindet. Die n⁻-leitende Schicht 3 wird im bekannten Fall epitaktisch auf dem p-leitenden Substrat 2 abgeschieden. In der n⁻-leitenden Schicht 3 ist eine n⁺-leitende Kollektorzone 4 eingelassen. In dem Halbleiterkörper 1 ist ferner eine n⁺-leitende Emitterzone 5 eingelassen, die von einer p-leitenden Basiszone 6 umgeben ist. Die n⁻-leitende Schicht 3, die auch als Driftschicht bezeichnet wird, dient in bekannter Weise im wesentlichen dazu, die zulässige Kollektorspannung des lateralen Transistors zu erhöhen. An dem Halbleiterkörper 1 sind ein Basiskontakt 7, ein Emitterkontakt 8 und ein Kollektorkontakt 9 angebracht. Um eine ohmsche Kontaktierung der Basiszone 6 zu gewährleisten, wird im Bereich der Basiskontaktierung 7 eine stark dotierte p⁺-leitende Zone 11 vorgesehen.

Im eingeschalteten Zustand fliesst ein Elektronenstrom von dem Emitter 5 zu der Kollektorzone 4.

Dieser Strom wird in bekannter Weise durch den Basistrom gesteuert . In der n⁻-Schicht wird bei Sperrpolung des Kollektor-Basis-Übergangs der Strom ausschliesslich als Feld- oder Driftstrom geführt, daher wird diese Schicht als Driftschicht bezeichnet. Durch eine entsprechend hohe Dotierung der p-leitenden Basiszone 6 wird dafür gesorgt, dass die Raumladungszone des Kollektor-Basis-pn-Übergangs in der Basiszone nicht bis zu der Emitterzone 5 vordringt. Das Bauelement arbeitet bestimmungsgemäss also im Transistorbetrieb.

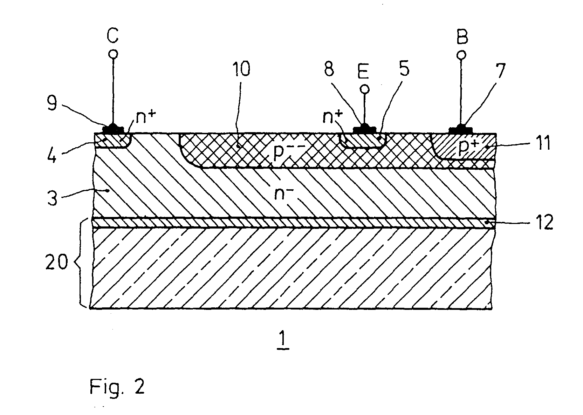

Bei einem lateralen Halbleiterbauelement gemäss der Erfindung (Fig. 2) besteht der Halbleiterkörper 1 bevorzugt aus einem isolierenden Substrat 20 mit einer Oxidschicht 12, auf deren Oberfläche eine n⁻-leitende Driftschicht 3 aufgebracht wurde. Der Ersatz eines Substrates mit einem sperrenden p-n Übergang (Sperrschichtisolation) durch ein isolierendes Substrat (dielektrische Isolation) gehört zum Stand der Technik. In die n⁻-leitende Driftschicht 3 ist ferner in bekannter Weise eine n⁺-leitende Kollektorzone 4 eingelassen. Abweichend zu dem bekannten Bauelement nach Fig. 1 erstreckt sich die dort mit 6 bezeichnete Basiszone nun in lateraler Richtung wesentlich weiter als der Ausdehnungsbereich der Emitterzone 5. Ferner ist diese Basiszone in eine p⁻⁻-leitende Teilzone 10 und eine p⁺-leitende Teilzone 11 unterteilt. Die p⁻⁻-leitende Teilzone (10) erstreckt sich auf der der Kollektorzone (4) zugewandten Seite und die p⁺-leitende Teilzone (11) auf der der Kollektorzone (4) abgewandten Seite der Basiszone. Der Basisanschluss 7 kontaktiert wieder die p⁺-leitende Teilzone 11. Die n⁺-leitende Emitterzone 5 wird von der p⁻⁻-leitenden Teilzone 10 umschlossen. Bei geringer Kollektor-Basis-Sperrspannung dehnt sich zunächst die Raumladungszone des pn-Übergangs zwischen der Driftschicht 3 und der p⁻⁻-leitenden Teilzone 10 in dieser Teilzone in Richtung auf die Emitterzone 5 aus, und das Bauelement arbeitet in bekannter Weise im Transistorbetrieb. Die Dotierung der p⁻⁻-leitenden Teilzone 10 und/oder auch das Dotierungsprofil dieser Teilzone sind nun so gewählt, dass ab einer technologisch einstellbaren Kollektorspannung die Raumladungszone der p⁻⁻-leitenden Teilzone 10 an die Emitterzone 5 angrenzt. Dies wird dann erreicht, wenn die p⁻⁻-leitende Teilzone 10 im Bereich zwischen der Emitterzone 5 und der Driftschicht 3 eine ausreichend geringe Anzahl Dotieratome pro Fläche enthält, und zwar typisch weniger als 2 x 10¹² Atome/cm².

Bei Kollektorspannungen oberhalb dieser vorgegebenen Spannung besteht dann eine Verbindung zwischen der Driftschicht 3 und der Emitterzone 5 über die Raumladungszone in der p⁻⁻-leitenden Teilzone 10 der Basiszone.

Oberhalb der vorgegebenen Spannung, bei der die Raumladungszone der schwach dotierten Teilzone der Basiszone an die Emitterzone 5 angrenzt, verliert das Bauelement den Charakter eines üblichen Transistors. Die Emitterzone 5 nimmt gegenüber dem Basisanschluss 7 eine Spannung an, die bei weiterem Anstieg der Kollektorspannung nur noch sehr wenig anwächst. Damit erfüllt das Bauelement die Funktion eines Spannungsteilers mit Begrenzung der Teilspannung. Es hat den Charekter einer Spannungsquelle, und es benötigt nur einen geringen Ruhestrom.

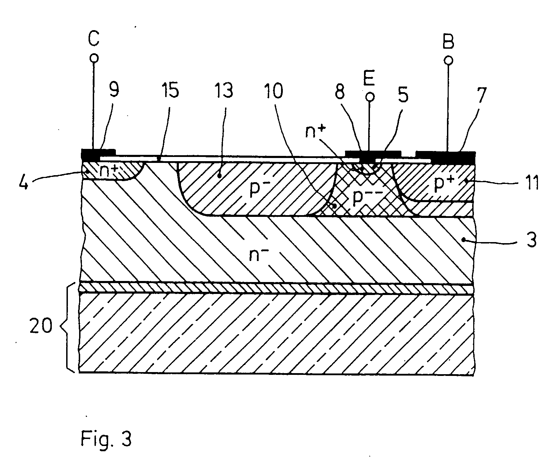

Das Bauelement gemäss Fig. 2 (bzw. Fig. 3, 4 und 5) lässt sich praktisch mit den gleichen Verfahrensschritten herstellen wie das bekannte laterale Halbleiterbauelement gemäss Fig. 1. Ausgangspunkt ist eine n⁻-Schicht, die in bekannter Weise wie bei Fig. 1 epitaktisch auf einem p-Substrat aufgebracht oder wie bei Fig. 2 mit einem dielektrisch isolierenden Substrat 20 verbunden wurde. In diese n⁻-Schicht, welche die Driftschicht 3 des fertigen Bauelements bildet, werden durch Diffusionsprozesse, in bekannter Weise, zunächst die schwach dotierte Teilzone der Basis und dann die stark dotierte p⁺-Basis eingebracht. Es folgen dann die stark dotierten Emitter- und Kollektorzone, die in einem Prozessschritt eingebracht werden. Die stark dotierten Zonen werden abschliessend kontaktiert.

Bei dem Ausführungsbeispiel gemäss Fig. 3, das eine Weiterbildung des Bauelements gemäss Fig. 2 darstellt, ist die schwach dotierte Teilzone der Basiszone in zwei Teilzonen unterteilt. Die Basiszone besteht aus einer stark dotierten p⁺-leitenden Teilzone 11, einer sehr schwach dotierten p⁻⁻-leitenden Teilzone 10 und einer stärker dotierten p⁻-leitenden Teilzone 13. Die p⁻-leitende Teilzone 13 erstreckt sich auf der der Kollektorzone 4 zugewandten Seite und umgibt die Teilzone 10. Die n⁺-leitende Emitterzone 5 ist in die p⁻⁻-leitende Teilzone 10 eingelassen. Das Ausführungsbeispiel gemäss Fig. 3 hat folgende Vorteile. Die Teilzone 10 der Fig. 2 soll einerseits gewährleisten, dass eine ausreichend hohe Sperrfähigkeit erreicht wird.

Dafür ist eine Reihe von Randbedingungen für das Dotierungsprofil aufrecht zu erhalten, andererseits soll die Raumladungszone den Emitter erreichen. Gemäss Fig. 3 gewährleistet die p⁻-leitende Teilzone 13 die erforderliche Sperrfähigkeit, die Teilzone 10 kann dann weitgehend unabhängig davon optimiert werden.

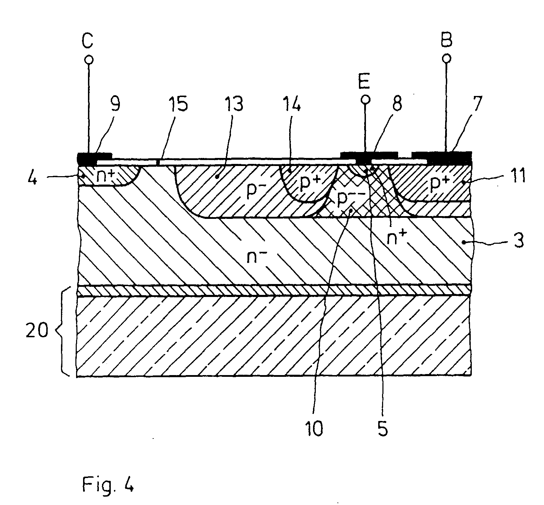

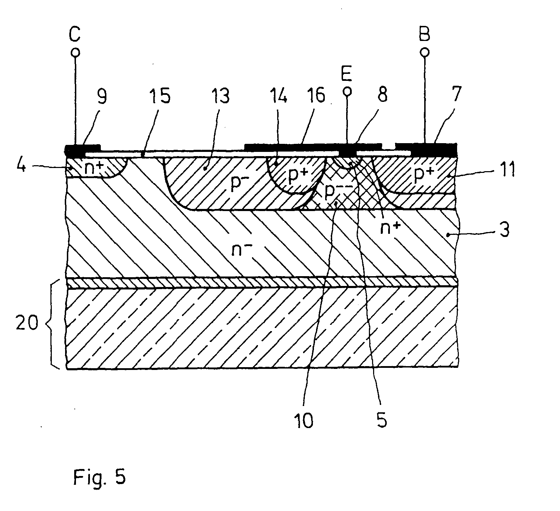

Durch eine weitgehende Differenzierung der Basiszone, wie sie in Fig. 4 dargestellt wird, lässt sich die Anforderung an eine Optimierung des Dotierungsprofils der Teilzone 13 weiter herabsetzen. Das bedeutet eine wesentliche Erleichterung für die praktische Ausführung und eine Steigerung der Ausbeute im Herstellungsprozess. Es ist eine weitere p⁺-leitende Teilzone 14 eingeführt, die im gleichen Herstellungsschritt wie die Teilzone 11 eingebracht wird und mit ihr elektrisch verbunden ist. Die Teilzone (14) ist in der p-leitenden Teilzone (13) der Emitterzone (5) gegenüberliegend eingelassen. In Fig. 5 ist zusätzlich eine Abschirmelektrode 16 eingeführt. Sie ist vom Halbleiterkörper durch eine Isolierschicht 15 getrennt und überdeckt die Bereiche der Zonen 10, 14 und teilweise 13. Sie liegt auf niedrigem Potential und schirmt daher den unter ihr liegenden Bauelementbereich von der Auswirkung sehr hoher Kollektorspannungen weitgehend ab. Dadurch wird die Emitterspannung besonders gut stabilisiert. Im bevorzugten Ausführungsbeispiel gemäss Fig. 5 ist diese Elektrode mit dem Emitteranschluss 8 elektrisch verbunden.

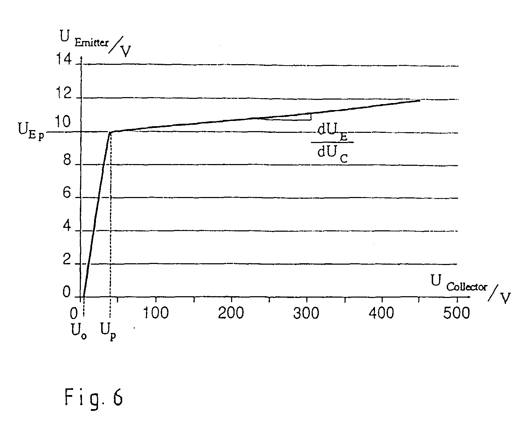

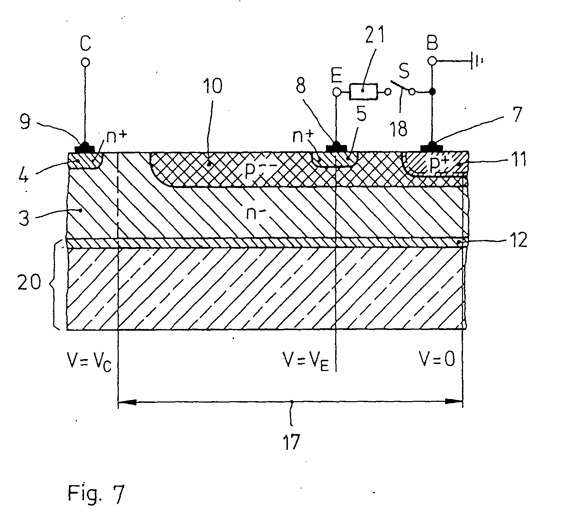

Die Funktion des Bauelements wird anhand Figuren 6 und 7 genauer erläutert.

Figur 6 zeigt eine typische Kennlinie der Struktur nach Fig. 2. Dargestellt ist die Emitterspannung U_{E} als Funktion der Kollektorspannung U_{C}, beide bezogen auf den Basisanschluss.

Von einer Kollektorspannung U_{O} an beginnt das Emitterpotential anzusteigen. Bei dieser Spannung U_{O} hat die Raumladungszone, wie in Figur 7 schematisch dargestellt, den Emitteranschluss erreicht. Mit weiterer Erhöhung dieser Spannung erreicht die Emitterspannung einen Wert U_{EP}, von dem ab sie nicht mehr sehr stark anwächst. Bei der entsprechenden Kollektorspannung U_{P} hat die Raumladungszone den gesamten schwach n⁻-dotierten Bereich 3 unterhalb der p⁻-Zone verbraucht.

Der weitere Anstieg von U_{E} lässt sich durch geometrische Massnahmen (Verlängerung der Zone 10 in Richtung des Kollektoranschlusses) und die in den Fig. 3 bis 5 dargestellten Massnahmen sehr gering halten, so dass es möglich ist, eine fast konstante Emitterspannung zu erhalten.

Falls über den Schalter 18, wie in Fig. 7 schematisch dargestellt, der Emitteranschluss mit dem Basisanschluss durch einen ohmschen Widerstand R 21 verbunden wird, fliesst ein Strom, der bei genügend grossen Widerständen R der Spannung U_{E}, dividiert durch R, entspricht. Allerdings wird mit absinkendem R der Strom nicht beliebig gross, er nimmt einen maximalen Wert an, als ob ein fester Vorwiderstand bereits im Emitteranschluss vorhanden wäre. Tatsächlich handelt es sich jedoch überwiegend um eine Raumladungsbegrenzung des Stromes.

Da dieser Strom als Kollektorstrom fliesst, hat das Bauelement den Charakter einer durch den Widerstand R steuerbaren Stromquelle mit sehr hohem wirksamen Innenwiderstand, es ist in guter Näherung eine Konstantstromquelle. Damit eignet sich das Bauelement hervorragend zur Übertragung von analogen und digitalen Signalen von niedrigem auf hohes Potential. Gerade die Unabhängigkeit des übertragenen Stroms von der Kollektorspannung ist eine wesentliche Forderung an solche Bauelemente zur Signalübertragung zwischen Funktionsblöcken unterschiedlichen Potentials.

Ferner kann das erfindungsgemässe Halbleiterbauelement in besonders vorteilhafter Weise auch noch für andere elektrische bzw. elektronische Anwendungszwecke eingesetzt werden, wobei eine Verwendung in integrierten Schaltkreisen im Vordergrund steht.

So kann z. B. der Emitteranschluss dazu dienen, einen Kondensator für eine interne Energieversorgung auf ein relativ niedriges Potential aufzuladen. Dies ist insofern bei der integrierten Schaltungstechnik von besonderer Bedeutung, da dort keine Transformatoren eingesetzt werden können und andererseits das Heruntersetzen einer Spannung über einen ohmschen Spannungsteiler immer mit Verlusten verbunden ist.

Es ist auch möglich, das Bauelement als Spannungssensor einzusetzen und es dazu so auszulegen, dass die Steigung der Emitterspannung nach überschreiten der Spannung U_{EP} relativ gross bleibt (Fig. 2). Dies kann durch eine Verkürzung der Basisschicht in Fig. 10 realisiert werden. Es ist dann möglich, den relativ niedrigen Wert des Emitterpotentials als Mass für die Grösse des relativ hohen Kollektorpotentials zu verwenden.

Auch hier gilt, dass im Gegensatz zu einem ohmschen Spannungsteiler diese Anordnung nur einen vernachlässigbaren Ruhestrom führt.

Es ist auch ein Einsatz des Bauelements als Schwellenwertgeber möglich. Dabei werden als Schwellenwert der Spannungswert bei der Einsatzspannung U_{CO} bzw. die zugehörige Emitterspannung gewählt. Es tritt auch in diesem Falle praktisch keine Verlustleistung auf. Durch entsprechende Bemessung des Halbleiterbauelements lässt sich die Einsatzspannung U_{CO} in einem weiten Bereich oberhalb einiger Volt einstellen.

Das Halbleiterbauelement gemäss der Erfindung behält seine grundlegende Funktionsweise und die daraus resultierenden Anwendungsmöglichkeiten auch in einer komplementären Auslegung, bei welcher der jeweilige Leitungstyp der Dotierbereiche invertiert wird. Die in Fig. 7 schematisch dargestellten Schalter 18 und Widerstand 21 können durch einen Halbleiterschalter, bevorzugt einen Feldeffekttransistor, ersetzt werden.

## Patentansprüche

1. Laterales Halbleiterbauelement aus einem Halbleiterkörper mit einer n⁻-leitenden Driftschicht (3) auf einem Substrat, einer in die Driftschicht eingelassenen n⁺-leitenden Kollektorzone (4), einer sich unterhalb der Oberfläche des Halbleiterkörpers mit Abstand von der n⁺-leitenden Kollektorzone lateral erstreckenden, p-leitenden Basiszone (6), einer in die p-leitende Basiszone (6) eingelassenen n⁺-leitenden Emitterzone (5) und mit jeweils einem Kontakt an der Basis- (6), Emitter- (5) und Kollektorzone (4),
**dadurch gekennzeichnet,**
daß die Basiszone (6) eine schwach dotierte p⁻⁻-leitende Teilzone (10) und eine stark dotierte p⁺-leitende, mit dem Basiskontakt (7) versehene Teilzone (11) aufweist, daß die schwach dotierte Teilzone (10) der Basiszone (6) zumindest teilweise an die n⁺-leitende Emitterzone (5) angrenzt und daß die p⁻⁻-leitende Teilzone (10) so schwach dotiert ist und/oder von der Emitterzone (5) zur Driftschicht (3) ein so stark abnehmendes Dotierungsprofil aufweist, daß bei einer vorbestimmten Kollektorspannung sich die Raumladungszone der zwischen der n⁻-leitenden Driftschicht (3) und der p⁻⁻-leitenden Basiszone (10) gebildete pn-Übergang in der p⁻⁻-leitenden Teilzone (10) bis zur n⁺-leitenden Emitterzone (5) erstreckt, so daß die Emitterzone (5) mit der Driftschicht (3) er die Raumladungszone in Verbindung steht, und daß das Substrat (20) p-leitend ist oder eine isolierende Schicht (12) aufweist.

2. Halbleiterbauelement nach Anspruch 1,
**dadurch gekennzeichnet,**
dass sich die p⁻⁻-leitende Teilzone (10) auf der der Kollektorzone (4) zugewandten Seite und die p⁺-leitende Teilzone (11) auf der der Kollektorzone (4) abgewandten Seite der Basiszone erstreckt.

3. Halbleiterbauelement nach Anspruch 1 oder 2,
**dadurch gekennzeichnet**,
dass sich an die schwach dotierte p⁻⁻-leitende Teilzone (10) der Basiszone zur Kollektorzone (4) hin eine stärker dotierte p⁻-leitende Teilzone (13) anschliesst derart, dass bei einer niedrigen Kollektorspannung sich die Raumladungszone zunächst in der p⁻⁻-leitenden Teilzone (10) bis zur Emitterzone (5) erstreckt.

4. Halbleiterbauelement nach Anspruch 2 oder 3,
**dadurch gekennzeichnet**,
dass in der p⁻-leitenden Teilzone (13) der Emitterzone (5) gegenüberliegend ein weiterer p⁺-leitende Teilzone (14) eingelassen ist.

5. Halbleiterbauelement nach Anspruch 4,
**dadurch gekennzeichnet**,
dass eine mit dem Emitterkontakt (8) verbundene Abschirmelektrode (16) über eine Isolierschicht (15) auf der Oberfläche des Halbleiterkörpers mindestens teilweise die Zonen (10, 13, 14) bedeckt.

6. Halbleiterbauelement nach einem der Ansprüche 1 bis 5,
**dadurch gekennzeichnet**,
dass das Halbleiterbauelement als komplementäre Struktur ausgebildet ist.

7. Halbleiterbauelement nach einem der Ansprüche 1 bis 6,
**dadurch gekennzeichnet**,
dass es als schaltbare Stromquelle verwendet wird.

8. Halbleiterbauelement nach Anspruch 7,
**dadurch gekennzeichnet**,
dass zwischen den Kontakten der Emitterzone und der Basiszone ein Schalter (18) angeordnet ist.

9. Halbleiterbauelement nach einem der Ansprüche 1 bis 8,
**dadurch gekennzeichnet**,
dass es zur Energieversorgung verwendet wird, in dem der Emitteranschluss über einen Kondensator ein relativ niedriges Potential bereitstellt.

10. Halbleiterbauelement nach einem der Ansprüche 1 bis 8,
**dadurch gekennzeichnet**,
dass es als Spannungssensor verwendet wird, in dem die Emitterspannung oberhalb einer Spannung U_{EP} (Fig. 6) als Mass für die relativ hohe Kollektorspannung herangezogen wird.

11. Halbleiterbauelement nach einem der Ansprüche 1 bis 8,
**dadurch gekennzeichnet**,
dass es als Schwellenwertgeber verwendet wird, in dem die Einsatzspannung U_{CO} der Kollektorspannung als Schwellenwert dient, wobei die Einsatzspannung durch geeignete Dimensionierung des Halbleiterbauelements sich auf einen vorbestimmten Wert einstellen lässt.

## Claims

1. Lateral semiconductor component of a semiconductor body with an n⁻-conductive drift layer (3) on a substrate, an n⁺-conductive collector zone (4) let into the drift layer, a p-conductive base zone (6) extending laterally below the surface of the semiconductor body at a spacing from the n⁺-conductive collector zone, an n⁺-conductive emitter zone (5) let into the p-conductive base zone (6) and with a respective contact at the base zone (6), the emitter zone (5) and the collector zone (4), characterised thereby, that the base zone (6) comprises a weakly doped p⁻⁻-conductive partial zone (10) and a strongly doped p⁺-conductive partial zone (11), which is provided with the base contact (7), that the weakly doped partial zone (10) of the base zone (6) at least partially adjoins the n⁺-conductive emitter zone (5) and that the p⁻⁻-conductive partial zone (10) is so weakly doped and/or displays a doping profile reducing so strongly from the emitter zone (5) to the drift layer (3) that the space charge zone of the pn-transition, which is formed between the n⁻-conductive drift layer (3) and the p⁻⁻-conductive base zone (10), for a predetermined collector voltage extends in the p⁻⁻-conductive partial zone (10) to the n⁺-conductive emitter zone (5) so that the emitter zone (5) stands in connection with the drift layer (3) by way of the space charge zone and that the substrate is p-conductive or comprises an insulating layer (12).

2. Semiconductor component according to claim 1, characterised thereby, that the p⁻⁻-conductive partial zone (10) extends on that side of the base zone, which faces the collector zone (4) and the p⁺-conductive partial zone (11) extends on that side of the base zone, which is remote from the collector zone (4).

3. Semiconductor component according to claim 1 or 2, characterised thereby, that a more strongly doped p⁻-conductive partial zone (13) adjoins the weakly doped p⁻⁻-conductive partial zone (10) of the base zone towards the collector zone in such a manner that the space charge zone for a low collector voltage extends initially in the p⁻⁻-conductive partial zone (10) to the emitter zone (5).

4. Semiconductor component according to claim 2 or 3, characterised thereby, that a further p⁺-conductive zone (14) is let into the p⁻-conductive partial zone (13) to lie opposite the emitter zone (5).

5. Semiconductor component according to claim 4, characterised thereby, that a screening electrode (16), which is connected with the emitter contact (8), above an insulating layer (15) on the surface of the semiconductor body at least partially covers the zones (10, 13, 14).

6. Semiconductor component according to one of the claims 1 to 5, characterised thereby, that the semiconductor component is formed as complementary structure.

7. Semiconductor component according to one of the claims 1 to 6, characterised thereby, that it is used as switchable current source.

8. Semiconductor component according to claim 7, characterised thereby, that a switch (18) is arranged between the contacts of the emitter zone and the base zone.

9. Semiconductor component according to one of the claims 1 to 8, characterised thereby, that it is used for energy supply in that the emitter connection makes a relatively low potential available by way of a capacitor.

10. Semiconductor component according to one of the claims 1 to 8, characterised thereby, that it is used as voltage sensor in that the emitter voltage above a voltage U_{EP} (Figure 6) is drawn upon as a measure for the relatively high collector voltage.

11. Semiconductor component according to one of the claims 1 to 8, characterised thereby, that it is used as threshold value generator in that the cut-off voltage U_{CO} of the collector voltage serves as threshold value, wherein the cut-off voltage lets itself be set to a predetermined value by suitable dimensioning of the semiconductor component.

## Revendications

1. Composant semi-conducteur latéral se composant d'un corps semi-conducteur muni d'une couche de dérive (3), à conduction du type n⁻, sur un substrat, d'une zone de collecteur (4), à conduction du type n⁺, enrobée dans la couche de dérive, d'une zone de base (6), à conduction du type p, s'étendant latéralement en dessous de la surface du corps semi-conducteur à distance de la zone de collecteur à conduction du type n⁺, d'une zone d'émetteur (5), à conduction du type n⁺, incorporée dans la zone de base (6), à conduction du type p et muni respectivement d'un contact à la zone de collecteur (4), d'émetteur (5) et de base (6),
caractérisé en ce que
la zone de base (6) présente une zone partielle (10), à conduction du type p⁻⁻, faiblement dopée, et une zone partielle (11), faiblement dopée, à conduction du type p⁺ et munie d'un contact de base (7), en ce que la zone partielle (10), faiblement dopée, de la zone de base (6) est du moins partiellement attenante à la zone d'émetteur (5), à conduction du type n⁺, et en ce que la zone partielle (10), à conduction du type p⁻, est faiblement dopée et/ou présente, entre la zone d'émetteur (5) et la couche de dérive (3), un profil de dopage décroissant de manière suffisamment forte pour qu'en présence d'une tension de collecteur prédéterminée, la zone de charge d'espace de la transition pn, formée entre la couche de dérive (3), à conduction du type n⁻, et la zone de base (10), à conduction du type p⁻⁻, s'étende dans la zone partielle (10), à conduction du type p⁻⁻, jusqu'à la zone d'émetteur (5), à conduction du type n⁺, de sorte que la zone d'émetteur (5) est reliée à la couche de dérive (3), par l'intermédiaire de la zone de charge d'espace, et en ce que le substrat (20) est à conduction du type p ou présente une couche isolante (12).

2. Composant semi-conducteur, selon la revendication 1, caractérisé en ce que
la zone partielle (10), à conduction du type p⁻⁻, s'étend sur la face tournée vers la zone de collecteur (4) et la zone partielle (11), à conduction du type p⁺, sur la face, détournée de la zone de collecteur (4), de la zone de base.

3. Composant semi-conducteur, selon la revendication 1 ou 2,
caractérisé en ce que
la zone partielle (10), à conduction du type p⁻⁻, faiblement dopée, de la zone de base se prolonge, en direction de la zone de collecteur (4) par une zone partielle (13), à conduction du type p⁻, plus fortement dopée, en ce qu'en présence d'une tension de collecteur faible, la zone de charge d'espace s'étend tout d'abord dans la zone partielle (10), à conduction du type p⁻⁻, jusqu'à la zone d'émetteur (5).

4. Composant semi-conducteur, selon la revendication 2 ou 3,
caractérisé en ce qu'
une autre zone partielle (14), à conduction du type p⁺, est incorporée dans la zone partielle (13), à conduction du type p⁻, en face de la zone d'émetteur (5).

5. Composant semi-conducteur, selon la revendication 4, caractérisé en ce qu'
une électrode de blindage (16), reliée au contact d'émetteur (8), recouvre, du moins partiellement, les zones (10, 13, 14), par l'intermédiaire d'une couche isolante (15) sur la surface du corps semi-conducteur.

6. Composant semi-conducteur, selon l'une des revendications 1 à 5,
caractérisé en ce que
le composant semi-conducteur fait office de structure complémentaire.

7. Composant semi-conducteur, selon l'une des revendications 1 à 6,
caractérisé en ce qu'
il sert de source de courant commutable.

8. Composant semi-conducteur, selon la revendication 7, caractérisé en ce qu'
un interrupteur (18) est disposé entre les contacts de la zone d'émetteur et la zone de base.

9. Composant semi-conducteur, selon l'une des revendications 1 à 8,
caractérisé en ce qu'
il est utilisé pour l'alimentation énergétique dans le fait que la borne d'émetteur dispose d'un potentiel relativement faible par l'intermédiaire d'un condensateur.

10. Composant semi-conducteur, selon l'une des revendications 1 à 8,
caractérisé en ce qu'
il est utilisé en tant que capteur de tension par le fait que la tension d'émetteur est amenée au-dessus d'une tension UEP (fig. 6) pour servir de mesure à la tension de collecteur relativement élevée.

11. Composant semi-conducteur, selon l'une des revendications 1 à 8,
caractérisé en ce qu'
il sert d'indicateur de valeur seuil, par le fait que la tension d'utilisation UCO sert de valeur de seuil à la tension de collecteur, la tension d'utilisation pouvant être réglée, par le biais d'un dimensionnement approprié du composant semi-conducteur, à une valeur prédéterminée.
